(19) Europäisches Patentamt

European Patent Office

Office européen des brevets

(11) **EP 0 998 029 A1**

(12) **EUROPÄISCHE PATENTANMELDUNG**

(43) Veröffentlichungstag:
03.05.2000 Patentblatt 2000/18

(51) Int. Cl.⁷: **H03F 3/217**, G05B 11/28

(21) Anmeldenummer: 98120059.5

(22) Anmeldetag: 23.10.1998

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder:
**Adeo Antriebstechnik GmbH**
**68167 Mannheim (DE)**

(72) Erfinder: **Schöller, Kurt**
**69502 Hemsbach (DE)**

(74) Vertreter:
**Schmid, Rudolf, Dipl.-Ing.,**
**Patentanwalt**
**Seckenheimer Strasse 36a**
**68165 Mannheim (DE)**

(54) **Elektromagnetisch verträglicher getakteter Verstärker für Gleich-/Wechselstromverstärkung**

(57) Die Erfindung betrifft einen elektromagnetisch verträglich, getakteten Verstärker für Gleichstrom-/Wechselstromverstärkung, insbesondere für Drehstrom-Winkelschritt-Antriebsregelsysteme, mit für jeweils eine Phase

einem Transistor-Brücken-Leistungsverstärker,
einem Ausgangsfilter und
einem Spannungssensor, wobei
der Transistor-Brücken-Leistungsverstärker mindestens einen ersten und einen zweiten Schalttransistor aufweist, zu denen jeweils Dioden parallel geschaltet sind, und
der Ausgangsfilter in Reihe geschaltet mindestens

einen Strombegrenzungswiderstand,
eine Filterinduktivität und
einen Ladekondensator aufweist und
Leistungsthyristoren nach den Spannungsvorzeichen gepolt, parallel zu dem Strombegrenzungswiderstand geschaltet sind.

Fig. 1

EP 0 998 029 A1

**Beschreibung**

Die Erfindung betrifft einen elektromagnetisch verträglichen getakteten Verstärker für Gleichstrom-/Wechselstromverstärkung mit einem Leistungsbereich von Watt bis Megawatt, insbesondere für Drehstrom-Winkelschritt-Antriebsregelsysteme, mit den Merkmalen des Anspruchs 1.

Bekannt ist es, in Leistungs-Endstufen zur Verstärkung von Signalen Transistoren zu verwenden und bekannt ist auch, daß Transistoren beim Ein- und Ausschalten nur einen relativ kleinen Kollektor-Strom führen können. Zur Begrenzung dieses Kollektor-Stroms ist es bekannt, eine Induktivität in Reihe mit den Transistoren zu schalten, die so bemessen wird, daß die Transistorströme ausreichend begrenzt werden. Ein Nachteil dieser Art Strombegrenzung ist es, daß bei großen Strömen oder Leistungen die Induktivität und damit die Leistungs-Endstufe groß und schwer wird. Eine in einer Leistungs-Endstufe zur Strombegrenzung in Reihe mit einem Transistor geschaltete Induktivität ist bekannt von sogenannten Tiefsetzstellern oder Buck-Convertern, die wiederum den Nachteil haben, nicht jede Art Eingangssignal zu verstärken.

Aufgabe der Erfindung ist es, einen kompakten, leichten, elektromagnetisch verträglichen, getakteten Verstärker für Gleichstrom-/Wechselstromverstärkung, insbesondere für Drehstrom-Winkelschritt-Antriebsregelsysteme, zu schaffen, der konstante oder frequenzabhängige Eingangssignale beliebig verstärken kann.

Die Lösung erfolgt mit einem elektromagnetisch verträglichen getakteten Verstärker für Gleichstrom/Wechselstromverstärkung, insbesondere für Drehstrom-Winkelschritt-Antriebsregelsysteme, mit den Merkmalen des Anspruchs 1. Vorteilhafte Ausgestaltungen der Erfindung sind in den Unteransprüchen dargestellt.

Gemäß der Erfindung ist ein elektromagnetisch verträglicher getakteter Verstärker für Gleichstrom/Wechselstromverstärkung, insbesondere für Drehstrom-Winkelschritt-Antriebsregelsysteme, für jeweils eine Phase mit einem Transistor-Brücken-Leistungsverstärker, einem Ausgangsfilter und einem Spannungssensor ausgestattet. Der Transistor-Brücken-Leistungsverstärker weist mindestens einen ersten und einen zweiten Schalttransistor auf, zu denen jeweils Dioden parallel geschaltet sind. Mit dem Ausgangsfilter in Reihe geschaltet sind ein Strombegrenzungswiderstand, eine Filterinduktivität und ein Ladekondensator. Nach Spannungsvorzeichen gepolte Leistungsthyristoren sind parallel zu dem Strombegrenzungswiderstand geschaltet.

Beim Einschalten eines ersten Schalttransistors des Transistor-Brücken-Leistungsverstärkers sind die parallel zu dem Strombegrenzungswiderstand geschalteten Leistungsthyristoren gesperrt, so daß Strom nur über den Strombegrenzungswiderstand und die Filterinduktivität fließt. Erfindungsgemäß sind der Strombegrenzungswiderstand und die Filterinduktivität so bemessen, daß der Kollektor-Strom des ersten oder zweiten Schalttransistors beim Einschalten auf eine zulässige Größe beschränkt bleibt. Ist der erste Schalttransistor durchgeschaltet, wird gemäß der Erfindung der dem ersten Schalttransistor zugeordnete Leistungsthyristor geschaltet, so daß der Strom nicht mehr über den Strombegrenzungswiderstand sondern über diesen zugeordneten Leistungsthyristor fließt, und folglich nimmt der Strom durch den Schalttransistor entsprechend der Spulenkonstanten I = L/R zu. Gemäß der Erfindung wird die Spannung nach der Filterinduktivität von dem Spannungssensor erfaßt und über eine Signalleitung an eine Steuereinheit für die ersten und zweiten Schalttransistoren weitergeleitet. Hat die Spannung nach der Filterinduktivität einen vorgegebenen Schwellwert überschritten, wird der erste Schalttransistor von der Steuereinheit abgeschaltet.

Auf das Abschalten des ersten Schalttransistors reagiert die Filterinduktivität mit einer der Spannung nach der Filterinduktivität entgegengesetzten Induktionsspannung, die erfindungsgemäß zunächst den bis dahin leitenden Leistungsthyristor löscht, so daß der Induktionsstrom vom Strombegrenzungswiderstand geschwächt über die zum zweiten Schalttransistor parallel geschaltete Diode abfließt beziehungsweise diese Seite der Filterinduktivität spannungsmäßig über diese Diode abstützt, so daß die gespeicherte Energie in Richtung Ladekondensator oder den angeschlossenen Verbraucher abfließen kann. Um jedoch, insbesondere bei höheren Ausgangsströmen den Energiegehalt der Filterinduktivität optimal zu nutzen, ist es vorteilhaft, den rückwärts gerichteten Leistungsthyristor zu zünden, so daß der Spulenstrom mit maximaler Stärke in Richtung Ladekondensator oder Ausgang zum Verbraucher abfließen kann.

Fällt die Spannung am Ladekondensator unter die Sollwertgrenze ab, wird der erste Schalttransistor wieder zugeschaltet und der Zyklus beginnt wieder wie oben beschrieben, solange die Steuereinheit dies vorgibt. Mit dem elektromagnetisch verträglichen, getakteten Verstärker für Gleichstrom-/Wechselstromverstärkung gemäß der Erfindung können Gleichstrom sowie Wechsel- oder Mischspannungen beliebiger Form und mit Frequenzen bis zu einigen hundert Hertz übertragen und verstärkt werden. Am erfindungsgemäßen Spannungssensor liegt proportional zur Eingangsspannung und unabhängig von Strombelastungen immer, auch wenn am Ausgang keine Last anliegt, eine um den eingestellten Verstärkungsfaktor verstärkte Ausgangsspannung an. Nur bei Überlast oder Kurzschluß liegt die um den eingestellten Verstärkungsfaktor verstärkte Ausgangsspannung nicht an. Der erfindungsgemäße Einsatz z. B. mindestens eines Strombegrenzungswiderstands sowie der zu diesem parallel geschalteten Leistungsthyristoren ermöglicht die Reduktion der Filterinduktivität um den Faktor 2 bis 10, so daß die Filterinduktivität gemäß der Erfindung geringeres Gewicht bei kleineren Abmessungen hat. Die kleinere Filterinduktivität erlaubt mit schnellerem Strom- bzw. Spannungsanstieg höhere Schaltfrequenzen der ersten und zweiten Schalttransistoren. Die Summe der Gewichte des erfindungsgemäßen Strombegrenzungswiderstands und der Filterinduktivität ist kleiner als das Gewicht einer Filterinduktivität nach dem Stand der Technik.

Gemäß einer vorteilhaften Ausgestaltung des erfindungsgemäßen elektromagnetisch verträglichen, getakteten Verstärker für Gleichstrom-/Wechselstromverstärkung werden die Leistungsthyristoren bei Strömen kleiner 20% des maximalen Stromes nicht geschaltet, so daß Resonanzen vermieden werden und eine verbesserte Regelgüte erreicht wird.

Die Erfindung soll im folgenden anhand eines Ausführungsbeispiels erläutert werden. Es zeigen:

Fig. 1: einen elektromagnetisch verträglichen getakteten Verstärker für Gleichstrom-/Wechselstromverstärkung gemäß der Erfindung,

Fig. 2: ein Verstärkungsdiagramm in Abhängigkeit von Zuständen der Schalttransistoren und der Leistungsthyristoren, und

Fig. 3: ein Verstärkungsdiagramm kleinen Strömen in Abhängigkeit von Zuständen der Schalttransistoren.

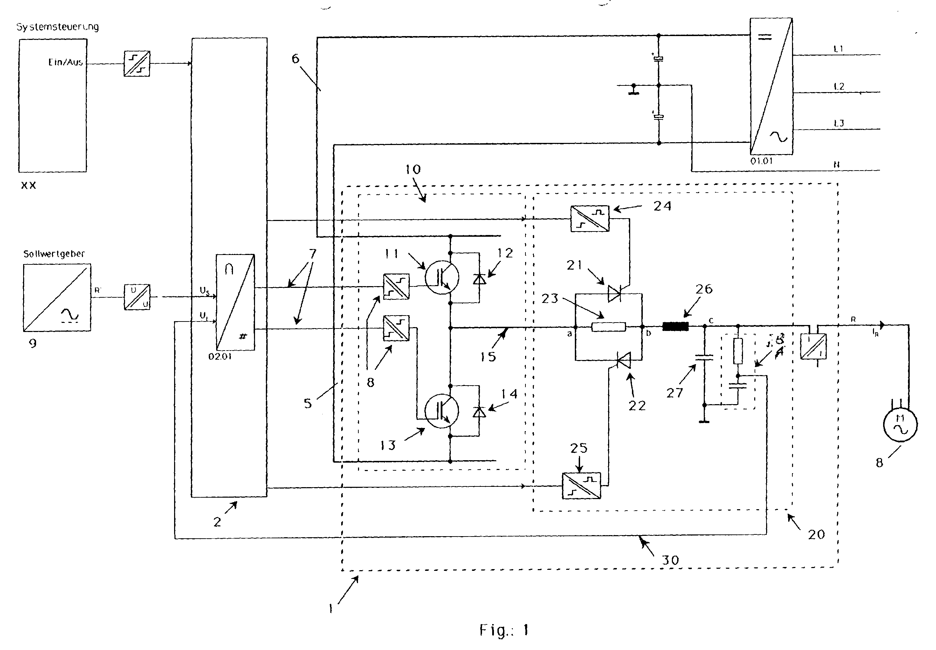

Fig. 1: Ein elektromagnetisch verträglicher, getakteter Verstärker für Gleichstrom-/Wechselstromverstärkung 1, insbesondere für Drehstrom-Winkelschritt-Antriebsregelsysteme, weist einen Transistor-Brücken-Leistungsverstärker 10, einen Ausgangsfilter 20 und einen Spannungsteiler 28 auf. Energie wird dem elektromagnetisch verträglichen getakteten Verstärker für Gleichstrom-/Wechselstromverstärkung 1 über Leitungen 5 und 6 zugeführt. Dargestellt ist der elektromagnetisch verträgliche, getaktete Verstärker für Gleichstrom-/Wechselstromverstärkung 1 für eine Phase. Bei drei Phasen widerholen sich die Komponenten des elektromagnetisch verträglichen, getakteten Verstärker für Gleichstrom-/Wechselstromverstärkung 1 je dreimal. Eine Steuereinheit 2 wird mit Sollwerten von einem Sollwertgeber 9 und mit Istwerten vom Spannungsteiler 28 beaufschlagt und gibt Signale über Steuerleitungen und -elemente 7 aus. Steuereinheit 2 ist pro Phase ein Zweipunktregler, die von dem Sollwertgeber 9 mit Eingangssignalen beaufschlagt wird. Der Sollwertgeber 9 kann z. B. der Ausgang eines digital gesteuerten Oszillators, wie in der ePa 96114782.4 sein.

Der Transistor-Brücken-Leistungsverstärker 10 weist einen ersten Schalttransistor 11 und einen zweiten Schalttransistor 13 auf, zu denen jeweils Dioden 12, 14 parallel geschaltet sind. Die ersten und zweiten Schalttransistoren 11, 13 werden von der Steuereinheit 2 über die Steuerleitungen und -elemente 7 angesteuert, d. h. leitend geschaltet oder abgeschaltet. Der erste Schalttransistor 11 ist mit Leitung 5 und der zweite Schalttransistor 13 mit Leitung 6 verbunden. Die Durchlaßrichtung von Diode 12 ist zur Leitung 5 und die Durchlaßrichtung von Diode 14 ist zur Leitung 6 gerichtet. Die ersten und zweiten Schalttransistoren 11, 13 sind mit einer Leitung 15 verbunden.

Leitung 15 führt zu dem Ausgangsfilter 20, in dem in Reihe geschaltet sind ein Strombegrenzungswiderstand 23, eine Filterinduktivität 26 und ein Ladekondensator 27. Nach Spannungsvorzeichen gepolte Leistungsthyristoren 21, 22 sind parallel zu dem Strombegrenzungswiderstand 23 geschaltet. Die Leistungsthyristoren 21, 22 werden von der Steuereinheit 2 jeweils über Zündelemente 24, 25 gesteuert. Spannungsteiler 28 ist zwischen Filterinduktivität 26 und Ladekondensator 27 angeordnet. An Spannungsteiler 28 kann eine Last oder Verbraucher 8, wie z. B. ein Synchron-Motor, angeschlossen sein.

Verfahren zum Betrieb des erfindungsgemäßen elektromagnetisch verträglichen, getakteten Verstärker für Gleichstrom-/Wechselstromverstärkung 1

Das Zünden des Leistungsthyristors 22 ist im Falle einer lastfreien Regelung, - wenn also keine Last am Ausgang anliegt -, nicht zwingend. Es wird dadurch lediglich eine kürzere Spannungsanstiegszeit am Spannungsmeßpunkt 26c erreicht. Ob im Leerlauf der Sollwertpegel im eingeschwungenen Zustand in 5, in 10, oder in 20 μsec erreicht ist, dürfte in diesem Fall keine besondere Rolle spielen, so daß im Leerlaufbetrieb auf die Schaltfunktion der Leistungsthyristoren 21, 22 gänzlich verzichtet werden kann.

Eine Spannung von beispielsweise +200 Volt liege an der Leitung 5 und eine Spannung von -200 Volt an der Leitung 6 an. Vom Sollwertgeber 9 werden z. B. Eingangssignale mit einem Pegel zwischen + 4 Volt und -4 Volt, die um einen einstellbaren, in der Steuereinheit vorgegebenen Faktor verstärkt werden sollen, an die Steuereinheit 2 vorgegeben.

Das folgende Ausführungsbeispiel gilt für die Verstärkung auf einen konstanten Pegel, wobei am Ausgang keine Last anliegen soll.

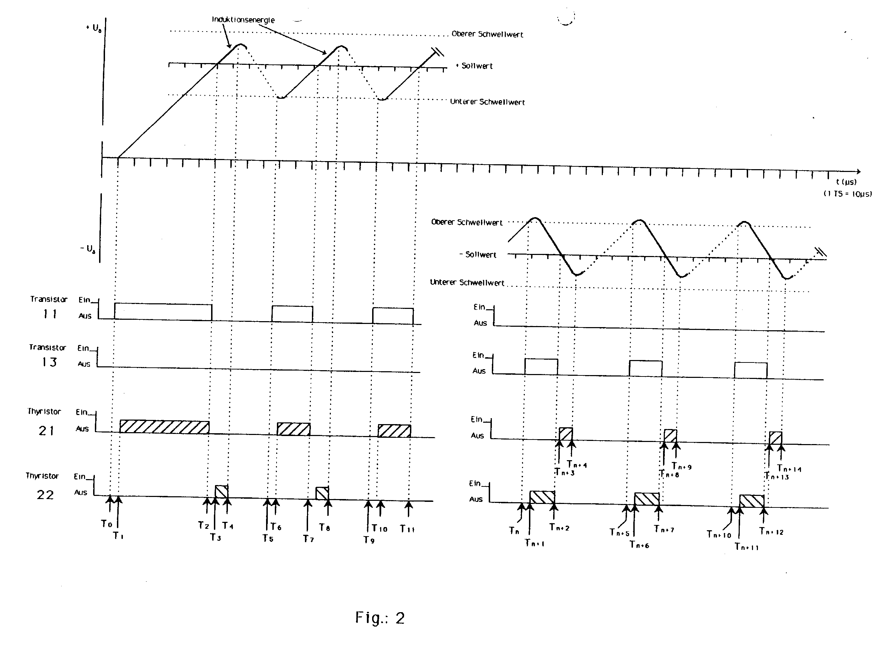

Fig. 2, linkes Diagramm: Soll ein Eingangssignal um einen positiven Faktor verstärkt werden, schaltet die Steuereinheit 2 zum Zeitpunkt $T_0$ zunächst den ersten Schalttransistor 11 leitend. Strom fließt zunächst von Leitung 5 durch den ersten Schalttransistor 11, den Strombegrenzungswiderstand 23, die Filterinduktivität 26 und in den Ladekondensator 27. Nach einer charakteristischen Einschaltzeit von ca. 2 μsek für den ersten Schalttransistor 11 wird zum Zeitpunkt $T_1$ von der Steuereinheit 2 der Leistungsthyristor 21 gezündet, und der Strom fließt über den Leistungsthyristor 21, die Filterinduktivität 26 und in den Ladekondensator 27. Der Strom durch den ersten Schalttransistor 11 steigt nun proportional zur Konstanten der Filterinduktivität 26 an bis zum Zeitpunkt $T_2$ am Spannungsteiler 28 zwischen Filterinduktivität 26 und Ladekondensator 27 eine Spannung gemessen wird und über die Leitung 30 an die Steuereinheit 2 weitergegeben wird. Steuereinheit 2 schaltet bei $T_2$ den ersten Schalttransistor 11 ab. Zeitgleich wird von der Filterinduktivität 26 induzierten Gegenspannung auch der Leistungsthyristor 21 gelöscht.

Die Spannung am Spannungsteiler 28 schießt noch leicht über den Schwellwert. Das Zünden des Leistungsthyristors 21 ist im Falle einer lastfreien Regelung, - wenn also keine Last am Ausgang anliegt - , nicht zwingend. Es wird dadurch lediglich eine kürzere Spannungsanstiegszeit am Spannungsmeßpunkt 26c erreicht. Ob im Leerlauf der Sollwertpegel im eingeschwungenen Zustand in 5, in 10, oder in 20 µsec erreicht ist, dürfte in diesem Fall keine besondere Rolle spielen, so daß im Leerlaufbetrieb auf die Schaltfunktion der Leistungsthyristoren 21, 22 gänzlich verzichtet werden kann.

Fig. 2, rechtes Diagramm: Soll ein Eingangssignal um einen negativen Faktor verstärkt werden, schaltet die Steuereinheit 2 zunächst $T_0$ den zweiten Schalttransistor 13 leitend. Strom fließt zunächst von Leitung 6 durch den zweiten Schalttransistor 13, den Strombegrenzungswiderstand 22, die Filterinduktivität 26 und in den Ladekondensator 27. Nach einer charakteristischen Einschaltzeit von ca. 2 µsek für den zweiten Schalttransistor 13 wird von der Steuereinheit 2 bei $T_{n+1}$ der Leistungsthyristor 22 gezündet, und der Strom fließt über den Leistungsthyristor 22, die Filterinduktivität 26 und in den Ladekondensator 27. Der Strom durch den zweiten Transistor 13 nimmt nun proportional zur Konstanten der Filterinduktivität 26 ab bis bei $T_{n+2}$ am Spannungsteiler 28 zwischen Filterinduktivität 26 und Ladekondensator 27 eine Spannung gemessen wird und über die Leitung 30 an die Steuereinheit 2 weitergegeben wird, die einem in Steuereinheit 2 voreingestellten Schwellwert entspricht. Steuereinheit 2 schaltet bei $T_{n+2}$ den zweiten Schalttransistor 13 ab. Zeitgleich wird auch der Leistungsthyristor 22 gelöscht.

Die Spannung am Spannungsteiler 28 schießt noch leicht über den eingestellten Sollwert. Unmittelbar anschließend $T_{n+5}$ wird wieder Schalttransistor 13 zugeschaltet und wieder zeitverzögert $T_{n+6}$ der Leistungsthyristor 22 gezündet bis wieder der Schwellwert am Spannungsteiler 28 erreicht ist, u. s. w. ...

Das folgende Ausführungsbeispiel gilt für die Verstärkung auf ein sinusförmiges Ausgangssignal, wobei angenommen wird, daß am Ausgang keine Last anliegen soll.

Soll ein sinusförmiges Eingangssignal um einen positiven Faktor verstärkt werden, schaltet die Steuereinheit 2 zunächst den ersten Schalttransistor 11 leitend. Strom fließt zunächst von Leitung 5 durch den ersten Schalttransistor 11, den Strombegrenzungswiderstand 23, die Filterinduktivität 26 und in den Ladekondensator 27. Nach der charakteristischen Einschaltzeit von ca. 2 µsek für den ersten Schalttransistor 11 wird von der Steuereinheit 2 der Leistungsthyristor 21 gezündet, und der Strom fließt über den Leistungsthyristor 21, die Filterinduktivität 26 und in den Ladekondensator 27. Der Strom durch den ersten Schalttransistor 11 steigt nun proportional zur Konstanten der Filterinduktivität 26 an bis am Spannungsteiler 28 zwischen Filterinduktivität 26 und Ladekondensator 27 eine Spannung gemessen wird und über die Leitung 30 an die Steuereinheit 2 weitergegeben wird. Nach Erreichen des vorgegebenen Sollwerts schaltet Steuereinheit 2 den ersten Schalttransistor 11 ab. Zeitgleich wird auch der Leistungsthyristor 21 gelöscht.

Die Spannung am Spannungsteiler 28 schießt noch leicht über diesen aktuellen Sollwert. Fällt die Spannung am Ladekondensator wieder ab wird wieder der erste Schalttransistor 11 zugeschaltet und zeitverzögert der Leistungsthyristor 21 gezündet bis wiederum der Sollwert zu dem aktuellen Eingangssignal am Spannungsteiler 28 erreicht ist, u. s. w. ...

Hat das sinusförmige Eingangssignal einen maximalen Betrag erreicht und wird anschließend vom Sollwertgeber 9 ein Eingangssignal mit kleinerer Amplitude vorgegeben, muß folglich das Eingangssignal um einen negativen Faktor verstärkt werden. Hierzu schaltet die Steuereinheit 2 zunächst den zweiten Schalttransistor 13 leitend. Strom fließt zunächst von Leitung 6 durch den zweiten Schalttransistor 13, den Strombegrenzungswiderstand 23, die Filterinduktivität 26 und in den Ladekondensator 27. Nach einer charakteristischen Einschaltzeit von ca. 2 µsek für den zweiten Schalttransistor 13 wird von der Steuereinheit 2 der Leistungsthyristor 22 gezündet, und der Strom fließt über den Leistungsthyristor 22, die Filterinduktivität 26 und in den Ladekondensator 27. Der Strom durch den zweiten Transistor 13 nimmt nun proportional zur Konstanten der Filterinduktivität 26 ab bis am Spannungsteiler 28 zwischen Filterinduktivität 26 und Ladekondensator 27 eine Spannung gemessen wird und über die Leitung 30 an die Steuereinheit 2 weitergegeben wird. Steuereinheit 2 schaltet dann den zweiten Schalttransistor 13 ab. Zeitgleich wird Leistungsthyristor 22 gelöscht. Das Zünden des Leistungsthyristors 22 ist im Falle einer lastfreien Regelung, - wenn also keine Last am Ausgang anliegt -, nicht zwingend. Es wird dadurch lediglich eine kürzere Spannungsanstiegszeit am Spannungsmeßpunkt 26c erreicht. Ob im Leerlauf der Sollwertpegel im eingeschwungenen Zustand in 5, in 10, oder in 20 µsec erreicht ist, dürfte in diesem Fall keine besondere Rolle spielen, so daß im Leerlaufbetrieb auf die Schaltfunktion der Leistungsthyristoren 21, 22 gänzlich verzichtet werden kann.

Die Spannung am Spannungsteiler 28 schießt noch leicht über den erreichten Sollwert. Fällt die Spannung am Ladekondensator 27 wieder unter den jeweiligen Sollwert ab wird wieder Schalttransistor 13 zugeschaltet und wieder zeitverzögert der Leistungsthyristor 23 gezündet bis wieder der obere Schwellwert am Spannungsteiler 28 erreicht ist, u. s. w. ...

Insbesondere für den Fall, daß eine Wechselspannung mit angeschlossener Last verstärkt werden soll, ist der wechselseitige Einsatz der Leistungsthyristoren 21, 22 von besonderer Bedeutung. Hierbei treten periodisch unterschiedliche Strombelastungen auf, die von 0 Ampere bis zum maximalen Strom reichen. Während im Bereich kleiner Ströme, - überwiegend am Nulldurchgang -, aus bereits genannten Gründen auf die Schaltfunktionen der beiden Leistungsthyristoren 21, 22 vorteilhaft verzichtet werden kann, da die Spulenenergie begrenzt wird, so müssen diese doch ab einer gewissen Stromstärke aktiv in den Regelkreislauf mit ein bezogen werden.

Hat das sinusförmige Eingangssignal einen minimalen Betrag erreicht und wird anschließend vom Sollwertgeber 9 ein Eingangssignal mit größerer Amplitude vorgegeben, muß wiederum das sinusförmige Eingangssignal wie oben beschrieben um einen positiven Faktor verstärkt werden, u. s. w. ...

Liegt eine Last 8 am Ausgang an, fließt Strom zur Last 8 ab und beeinflußt auf diese Weise den Spannungspegel am Spannungsteiler 28. Da Spannungsteiler 28 die Werte vorgibt, nach denen die Steuereinheit 2 die ersten und zweiten Schalttransistoren 11, 13 und die zugehörigen Leistungsthyristoren 21, 22 steuert, kann die Last die oben angegebene Abfolge des Zuschaltens der ersten und zweiten Schalttransistoren 11, 13 und der zugehörigen Leistungsthyristoren 21, 22 ändern.

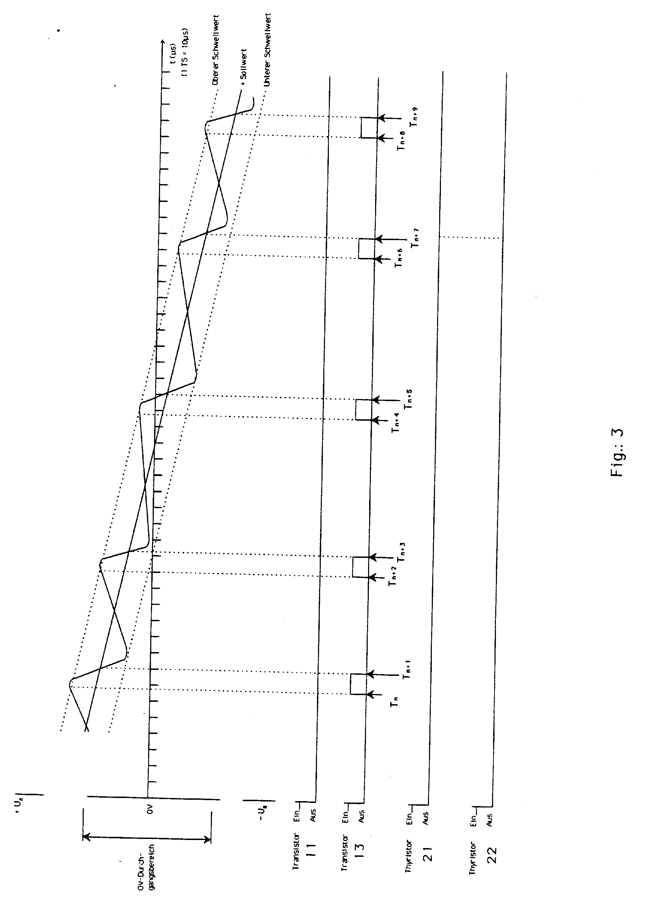

Fig. 3: Bei kleinen Strömen und einer Verstärkung von einem positiven zu einem negativen Stromwert ergibt sich eine Stromverstärkungsfunktion aus einem Einschalten von Transistor 13 bei $T_n$ und einem Ausschalten des Transistors 13 bei $T_{n+1}$. Nach einem leichten Überschießen kehrt die Stromverstärkungsfunktion von einem unteren Schwellwert zurück zu einem oberen Schwellwert, worauf das Ein- und Ausschalten von Transistor 13 sich wiederholt. Die Leistungsthyristoren 21, 22 werden nicht gezündet bis der Betrag des Stromwerts z. B. 20% des maximalen Stromwerts erreicht.

## Patentansprüche

1. Elektromagnetisch verträglicher, getakteter Verstärker für Gleichstrom-/Wechselstromverstärkung, insbesondere für Drehstrom-Winkelschritt-Antriebsregelsysteme, mit für jeweils eine Phase

   einem Transistor-Brücken-Leistungsverstärker,
   einem Ausgangsfilter und
   einem Spannungssensor, wobei
   der Transistor-Brücken-Leistungsverstärker mindestens einen ersten und einen zweiten Schalttransistor aufweist, zu denen jeweils Dioden parallel geschaltet sind, und
   der Ausgangsfilter in Reihe geschaltet mindestens
   einen Strombegrenzungswiderstand,
   eine Filterinduktivität und
   einen Ladekondensator aufweist und
   Leistungsthyristoren nach den Spannungsvorzeichen gepolt, parallel zu dem Strombegrenzungswiderstand geschaltet sind.

2. Elektromagnetisch verträglicher, getakteter Verstärker für Gleichstrom-/Wechselstromverstärkung gemäß Anspruch 1, dadurch gekennzeichnet, daß die Leistungsthyristoren bei Strömen kleiner 20% des maximalen Stromes nicht geschaltet werden.

Fig.: 1

Systemsteuerung

Ein/Aus

Sollwertgeber

Fig.: 2

EP 0 998 029 A1

Fig.: 3

**Europäisches Patentamt**

## EUROPÄISCHER RECHERCHENBERICHT

Nummer der Anmeldung

EP 98 12 0059

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | WO 95 13571 A (EXABYTE CORP) 18. Mai 1995 * Seite 4, Zeile 20 - Seite 8, Zeile 12; Abbildung 1 * | 1 | H03F3/217 G05B11/28 |
| A | EP 0 655 830 A (KAISER AEROSPACE & ELECTRONICS) 31. Mai 1995 * Seite 4, Zeile 41 - Seite 6, Zeile 40; Abbildung 6 * | 1 | |
| A | US 4 628 275 A (SKIPPER JOHN D ET AL) 9. Dezember 1986 * Spalte 6, Zeile 3 - Zeile 34; Abbildungen 4,5 * | 1 | |
| | | | **RECHERCHIERTE SACHGEBIETE (Int.Cl.6)** |
| | | | H03F G05B |

Der vorliegende Recherchenbericht wurde für alle Patentansprüche erstellt

| Recherchenort | Abschlußdatum der Recherche | Prüfer |
|---|---|---|
| DEN HAAG | 24. März 1999 | Tyberghien, G |

KATEGORIE DER GENANNTEN DOKUMENTE

X von besonderer Bedeutung allein betrachtet
Y von besonderer Bedeutung in Verbindung mit einer anderen Veröffentlichung derselben Kategorie
A technologischer Hintergrund
O nichtschriftliche Offenbarung
P Zwischenliteratur

T der Erfindung zugrunde liegende Theorien oder Grundsätze
E älteres Patentdokument, das jedoch erst am oder nach dem Anmeldedatum veröffentlicht worden ist
D in der Anmeldung angeführtes Dokument
L aus anderen Gründen angeführtes Dokument

& Mitglied der gleichen Patentfamilie, übereinstimmendes Dokument